# EUROPÄISCHE PATENTSCHRIFT

(11) **EP 0 721 644 B1**
(45) Veröffentlichungstag und Bekanntmachung des Hinweises auf die Patenterteilung: **02.12.1998**
(21) Anmeldenummer: 94926089.7
(22) Anmeldetag: 10.09.1994
(51) Int. Cl.: G11C 16/06

(54) **VERFAHREN ZUR VOLLSTÄNDIGEN NEUPROGRAMMIERUNG EINES LÖSCHBAREN, NICHTFLÜCHTIGEN SPEICHERS**
PROCESS FOR FULLY RE-PROGRAMMING AN ERASABLE NON-VOLATILE STORE
PROCEDE DE REPROGRAMMATION COMPLETE D'UNE MEMOIRE NON VOLATILE EFFACABLE

(30) Priorität: 24.09.1993 DE 4332499
(43) Veröffentlichungstag der Anmeldung: 17.07.1996
(73) Patentinhaber: ROBERT BOSCH GMBH, 70442 Stuttgart (DE)
(72) Erfinder: ZIMMERMANN, Juergen, D-71665 Vaihingen (DE); GROTE, Walter, D-71706 Markgroeningen (DE)
(86) Internationale Anmeldenummer: DE9401040
(87) Internationale Veröffentlichungsnummer: WO9508824

(56) Entgegenhaltungen:
- WO-A-80/02881
- US-A- 4 752 871
- IBM TECHNICAL DISCLOSURE BULLETIN., Bd.33, Nr.6B, November 1990, NEW YORK US Seiten 434 - 435 'ROS code integrity protection'
- IBM TECHNICAL DISCLOSURE BULLETIN., Bd.31, Nr.8, Januar 1989, NEW YORK US Seiten 73 - 74 'EPROM redundancy'
- PATENT ABSTRACTS OF JAPAN vol. 8, no. 179 (P-295) (1616) 17. August 1984 & JP,A,59 071 180 (DAINIPPON INSATSU KK) 21. April 1984

## Beschreibung

### Stand der Technik

Die Erfindung geht aus von einem Verfahren zur vollständigen Neuprogrammierung eines elektrisch löschbaren, nichtflüchtigen Speichers wie im Oberbegriff des Anspruchs 1 angegeben und wie z.B. aus IBM TDB, vol. 33, nr. 6b, Nov. 1990, p. 434 - 435 bekannt.

Ein weiteres Verfahren zur vollständigen Neuprogrammierung eines löschbaren, nichtflüchtigen Speichers aus der WO 80/02881 bekannt. Der löschbare, nichtflüchtige Speicher (EPROM) ist dabei auf dem Chip eines Mikrorechners enthalten. Zur Programmierung ist in dem ROM des Mikrorechners ein Programmiermodul enthalten. Zur Programmierung des löschbaren, nichtflüchtigen Speichers (EPROM) wird der Mikrorechner über eine serielle Schnittstelle mit einem Datenendgerät (Terminal) verbunden. Der Mikrorechner empfängt dann die einzuprogrammierenden Daten von dem Terminal. Für die Programmierung des löschbaren, nichtflüchtigen Speichers (EPROM) bedient sich der Mikrorechner des Programmiermoduls, das im ROM gespeichert ist.

### Vorteile der Erfindung

Das erfindungsgemäße Verfahren ist im Anspruch 1 angegeben. Zur vollständigen Neuprogrammierung eines löschbaren, nichtflüchtigen Speichers hat es den Vorteil, daß das Vorsehen eines teuren und vor allem nachträglich nicht mehr änderbaren ROMs mit einem Programmiermodul entfallen kann. Es ist nämlich erfindungsgemäß vorgesehen, daß das Programmiermodul zusätzlich mit auf dem löschbaren, nichtflüchtigen Speicher vorgesehen wird. Dieses Programmiermodul wird dann vor dem eigentlichen Programmiervorgang in den flüchtigen Speicher (Code-RAM) des Mikrorechners eingeladen und steht dort dann zur Abarbeitung bereit. Weiterhin vorteilhaft ist, daß der löschbare, nichtflüchtige Speicher auch zu einem späteren Zeitpunkt vollständig und sicher neu programmiert werden kann. Damit wird es möglich, z.B. bei einem Kraftfahrzeug-Steuergerät, daß nach seiner Auslieferung an den Kunden noch nachträgliche Programmänderungen möglich sind, ohne daß dazu das Kraftfahrzeug-Steuergerät z.B. aus dem Kraftfahrzeug. ausgebaut werden müßte und an das Herstellerwerk zurückgeschickt werden müßte. Dies ist deshalb auch von Vorteil, weil sich manchmal Programmänderungen erst bei dem Feldeinsatz des Kraftfahrzeug-Steuergerätes ergeben. Z.B. ist es möglich, daß es sich erst bei dem Feldeinsatz eines Kraftfahrzeuges herausstellt, daß der Motor unter bestimmten klimatischen Bedingungen unrund läuft, so daß eine bessere Einstellung des Motors für diesen Fall erforderlich wird. Hierzu muß jedoch das Steuerungsprogramm des Motor-Steuergerätes abgeändert werden. Mit der Erfindung ist nun sogar der vollständige Austausch des Steuerprogramms eines Kraftfahrzeug-Steuergerätes ohne Probleme möglich. Das Programmierverfahren ist dabei so ausgelegt, daß es mit einfachen Mitteln durchführbar ist, so daß die Neuprogrammierung des nichtflüchtigen, löschbaren Speichers auch in der Werkstatt durchgeführt werden kann. Es braucht dazu lediglich ein Kleincomputer, z.B. PC, vorhanden sein, der über die Diagnoseschnittstelle des Kraftfahrzeuges mit dem entsprechenden Kraftfahrzeug-Steuergerät verbunden wird. Die neuen Programmdaten können z.B. per Diskette an die Werkstatt geliefert werden. Diese Daten werden dann über den Kleincomputer und die Diagnoseschnittstelle an das Steuergerät übertragen. Ebenfalls vorteilhaft ist, daß die Programmierung fehlertolerant ausgelegt ist. Selbst ein grober Bedienungsfehler, z.B. daß durch Fehlbedienung vor dem Abschluß des Programmiervorgangs die Spannungsversorgung vom Kraftfahrzeug bzw. von dem Datenendgerät unterbrochen wird, führt nicht dazu, daß die Programmierung verunmöglicht wird. Es ist nämlich das Programmiermodul quasi doppelt in dem programmierbaren, nichtflüchtigen Speicher vorhanden, so daß selbst bei Löschung einer dieser Programmiermodule trotzdem noch ein intaktes Programmiermodul im Speicher enthalten ist. Der Programmiervorgang kann dann mit diesem intakten Programmiermodul noch weitergeführt werden. Ein weiterer Vorteil der Abspeicherung des Programmiermoduls im nichtflüchtigen, löschbaren Speicher ergibt sich daraus, daß damit der Steuergerätehersteller sein eigenes Programmiermodul entwicklen kann. Die Funktionsweise dieses Programmiermoduls braucht keiner größeren Öffentlichkeit zugänglich gemacht werden. Damit sind nachträgliche, unerlaubte Manipulationen des nichtflüchtigen, löschbaren Speichers erschwert.

Durch die in den Unteransprüchen aufgeführten Maßnahmen sind vorteilhafte Weiterbildungen und Verbesserungen des im Hauptanspruch angegebenen Verfahrens möglich. Das Programmiermodul kann selbst aus einzelnen Modulen bestehen. Sehr vorteilhaft ist, wenn nur ein Teil der Module des Programmiermoduls in den löschbaren, nichtflüchtigen Speicher eingeschrieben wird und die restlichen Module von dem externen, elektronischen Gerät in den flüchtigen Speicher nachgeladen werden. Dadurch wird Speicherplatz im löschbaren, nichtflüchtigen Speicher eingespart. Besonders vorteilhaft ist es, vor dem eigentlichen Programmiervorgang die Speicherinhalte des Speicherbereichs, in dem das Programmiermodul enthalten ist, auf Richtigkeit zu überprüfen und nur dann einen Bereich neu zu programmieren, wenn in dem anderen Bereich ein als fehlerfrei erkanntes Programmiermodul enthalten ist. Dadurch wird der Programmiervorgang weiter abgesichert.

Die Überprüfung kann besonders einfach dadurch stattfinden, daß die Speicherinhalte der Speicherbereiche, in denen das Programmiermodul enthalten ist, zu einer Checksumme zusammengerechnet werden, die mit einer ebenfalls in dem löschbaren, nichtflüchtigen Speicher eingetragenen Wert verglichen wird und daß der Speicherinhalt als fehlerfrei erkannt wird, wenn die berechnete Checksumme mit dem eingetragenen Wert übereinstimmt.

Weiterhin vorteilhaft ist, daß nach der Programmierung jedes der mindestens zwei Bereiche die Speicherinhalte dieser Bereiche auf Fehlerfreiheit überprüft werden und daß nur dann der nächste Bereich programmiert wird, wenn der zuvor programmierte Bereich als fehlerfrei erkannt wird. Auch hierdurch wird das Programmierverfahren weiterhin abgesichert.

Der Einfachheit halber kann das Programmiermodul zusammen mit dem Steuerprogramm für das Steuergerät am Ende der Produktion des Steuergerätes in jeden der mindestens zwei Bereiche des löschbaren, nichtflüchtigen Speichers eingeschrieben werden.

Um Speicherplatz zu sparen, ist es jedoch auch möglich, daß das Programmiermodul nur in einen der Bereiche des elektrisch löschbaren, nichtflüchtigen Speichers am Bandende der Produktion des Steuergerätes eingeschrieben wird und daß das Programmiermodul erst vor der Löschung des Bereiches, in dem schon ein Programmiermodul eingetragen ist, in den mindestens einen weiteren Bereich eingeschrieben wird.

### Zeichnung

Ein Ausführungsbeispiel der Erfindung ist in der Zeichnung dargestellt und in der nachfolgenden Beschreibung näher erläutert. Es zeigen Figur 1 ein grobes Blockschaltbild der Anordnung zur Programmierung des löschbaren, nichtflüchtigen Speichers; Figur 2 eine schematische Darstellung der Speicheraufteilung des löschbaren, nichtflüchtigen Speichers; Figur 3 ein Ablaufdiagramm für die Programmierung des löschbaren, nichtflüchtigen Speichers.

### Beschreibung der Erfindung

Die Erfindung betrifft das Gebiet der Kraftfahrzeug-Steuergeräte. Diese dienen z.B. der Motor-Steuerung, Getriebe-Steuerung, Brems-Steuerung, etc. Diese Steuergeräte enthalten Mikrorechner, die jeweils Steuerprogramme abarbeiten. Beim Feldeinsatz dieser Steuergeräte, d.h. nachdem die Steuergeräte in Kraftfahrzeuge eingebaut wurden und diese wiederum an private Kunden ausgeliefert wurden, ergeben sich unter Umständen Probleme, die vorher bei der Entwicklung nicht berücksichtigt wurden. So kann z.B. ein für den Kunden in einem bestimmten Drehzahlbereich des Motors unangenehmes Motorruckeln auftreten, das vorher z.B. zur Optimierung des Kraftstoffverbrauchs von Seiten der Entwicklung toleriert wurde. Um dieses Motorruckeln abzustellen, wäre eine Programmänderung des Steuerprogramms des Motor-Steuergerätes erforderlich. Z.B. müßte das Gemisch in dem entsprechenden Drehzahlbereich fetter eingestellt werden. Weitere Änderungswünsche können sich noch nachträglich ergeben. So besteht von Seiten der Kraftfahrzeughersteller der Wunsch, die Steuergeräte so auszulegen, daß sie auch nach Fertigstellung noch vollständig umprogrammiert werden können. Die Umprogrammierung sollte mit einfachen Mitteln in einer Werkstatt möglich sein. Hierzu bietet die Erfindung eine Lösung an.

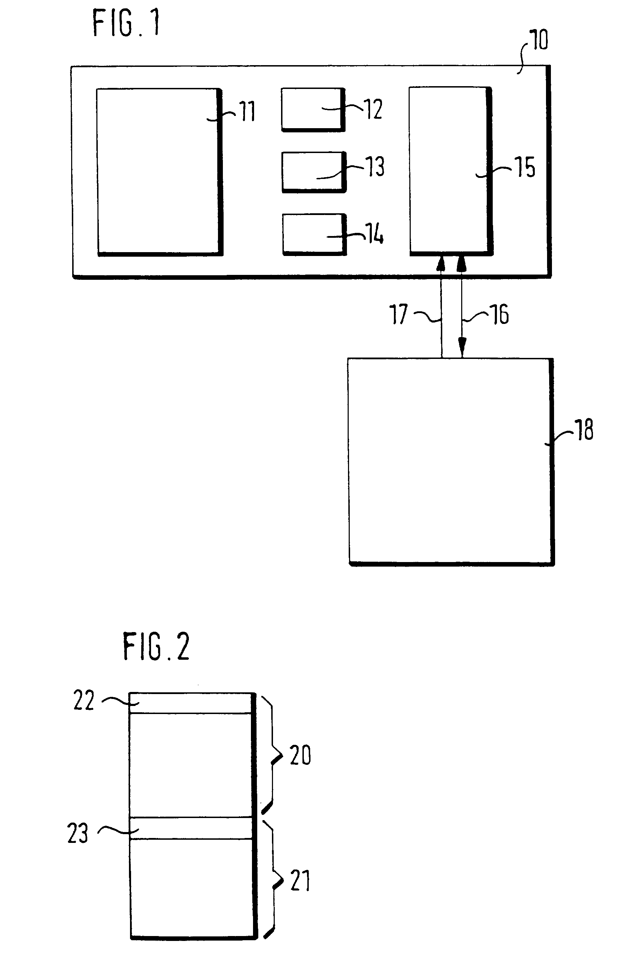

In der Figur 1 bezeichnet die Bezugszahl 10 ein Kraftfahrzeug-Steuergerät. Dieses enthält eine Zentraleinheit 11, einen löschbaren, nichtflüchtigen Speicher 12, einen flüchtigen Speicher 13, einen Nur-Lese-Speicher 14 sowie diverse Ein-/Ausgabe-Schaltkreise 15. Der löschbare, nichtflüchtige Speicher 12 kann vorteilhafterweise als Flash-EPROM ausgebildet sein. Diese Speicherart erlaubt nämlich sowohl eine hohe Speicherdichte, Nichtflüchtigkeit, als auch die Möglichkeit der elektrischen Löschung des Speicherinhaltes. Der flüchtige Speicher 13 weist als Besonderheit auf, daß in ihn oder zumindest in einen Teil von ihm Programmdaten einschreibbar sind, auf die die CPU direkt zugreifen kann. Der Nur-Lese-Speicher 14 ist als ROM bekannt. Das Steuergerät 10 ist über eine serielle Übertragungsleitung 16 mit einem Personalcomputer 18 verbunden. Über die separate Leitung 17 wird die Programmierspannung für die Programmierung des löschbaren, nichtflüchtigen Speichers 12 zu dem Steuergerät 10 eingespeist.

Flash-EPROMs weisen die Besonderheit auf, daß mit ihnen nur eine blockweise Löschung des gesamten Speicherinhaltes möglich ist. In Figur 2 ist der löschbare, nichtflüchtige Speicher 12 mit zwei getrennt voneinander löschbaren und programmierbaren Bereichen dargestellt. Die Speichereinteilung ist so gewählt, daß die beiden Blöcke 20 und 21 gleich groß sind. Beim Lesezugriff der Zentraleinheit 11 zu dem Flash-EPROM ist der Zugriff wahlfrei, so daß das Steuergeräteprogramm durchaus über beide Blöcke 20, 21 verteilt sein kann.

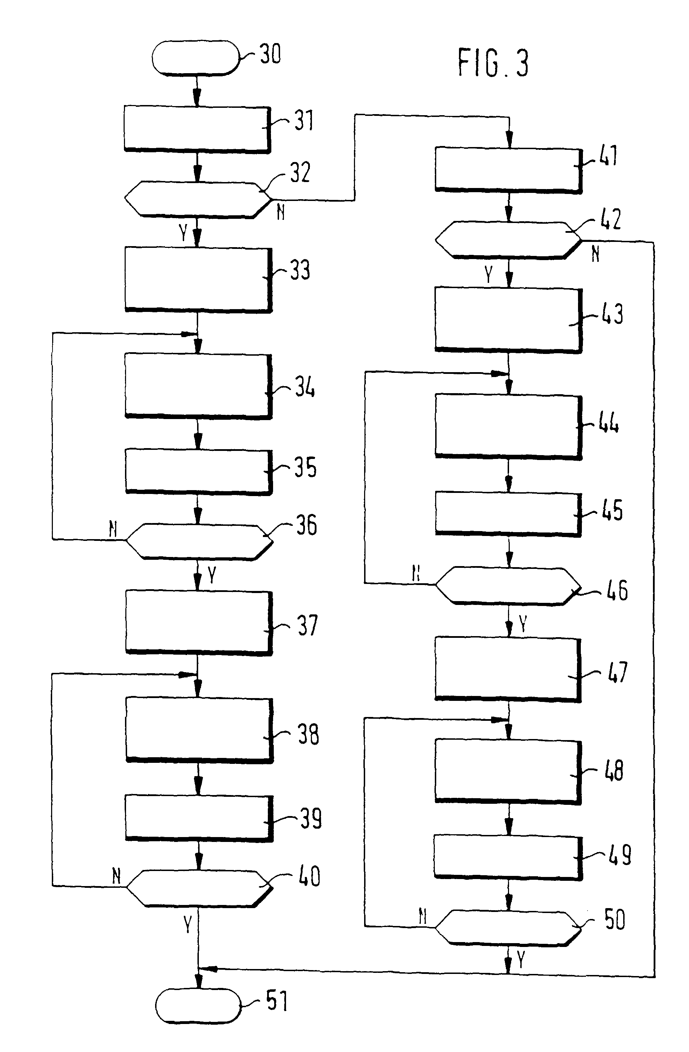

Bei der Fertigstellung des Kraftfahrzeug-Steuergerätes 10 wurde der löschbare, nichtflüchtige Speicher 12 mit dem Steuerprogramm beschrieben. Zusätzlich wurde in jeden der Speicherbereiche 20, 21 ein identisches Programmiermodul eingeschrieben. Diese Programmiermodule sind in die Speicherbereiche 22 und 23, die in Figur 2 dargestellt sind, eingeschrieben. Zur Umprogrammierung des Speichers 12 wird die Anordnung nach Figur 1 benutzt. Es wird also der Personalcomputer 18 über die serielle Datenübertragungsleitung 16 mit dem Kraftfahrzeug-Steuergerät 10 verbunden. Weiterhin wird über eine separate Anschlußleitung 17 die Programmierspannung an das Steuergerät 10 angelegt. Zur Programmierung werden die neuen Daten, die z.B. auf einem Datenträger wie einer Diskette von dem Herstellerwerk zur Verfügung gestellt werden, In den Personalcomupter 18 eingegeben. Nachdem das Steuergerät 10 durch Anlegen bestimmter Signale in den Programmiermodus geschaltet wurde, werden dann die Daten von dem Personalcomputer 18 sukzessive an das Kraftfahrzeug-Steuergerät 10 übertragen. Der konkrete Ablauf zur Programmierung des Speichers 12 wird im folgenden anhand des Ablaufdiagramms in Figur 3 beschrieben.

Mit der Bezugszahl 30 ist der Start des Programmiervorgangs bezeichnet. Die Zentaleinheit 11 arbeitet dann einen Programmteil ab, in dem der Speicherbereich 20 einer Überprüfung unterzogen wird. Die CPU 11 berechnet dabei eine Checksumme für diesen Speicherbereich. Dieser Wert wird dann mit einem Wert, der ebenfalls in diesem Bereich abgespeichert ist, verglichen. In Abfrage 32 ermittelt also die CPU 11, ob der Speicherinhalt des Speicherbereiches 20 fehlerfrei ist oder nicht. Im folgenden wird erstens angenommen, daß die Überprüfung des Speicherbereiches 20 ergeben hat, daß die dort eingeschriebenen Daten fehlerfrei sind. Im Programmschritt 33 wird dann der Speicherinhalt des Speicherbereiches 20 in den flüchtigen Speicher 13 übertragen und das dann darin abgespeicherte Programmiermodul gestartet. Dieses Programmiermodul ist dann weitgehend ein an sich schon aus dem Stand der Technik bekanntes Programm. Unter der Kontrolle dieses Programms findet z.B. die Kommunikation mit dem Personalcomputer 18 statt. Wesentlich ist, daß ebenfalls unter der Kontrolle dieses Programms in dem Programmschritt 34 der Speicherbereich 21 gelöscht wird und anschließend mit den neuen Daten, die von dem Personalcomputer 18 empfangen wurden, neu programmiert wird. Nach der Programmierung des Speicherbereiches 21 findet dann eine Überprüfung dieses Bereiches im Programmschritt 35 statt. Die Überprüfung kann ebenfalls wieder so durchgeführt werden, daß über den Speicherbereich 21 eine Checksumme berechnet wird, die mit einer von dem Personalcomputer empfangenen Checksumme verglichen wird. War die Programmierung fehlerhaft, wird dies in Abfrage 36 erkannt und es wird der Speicherbereich 21 erneut programmiert. Es folgen dann wieder die Programmschritte 34 und 35. War die Programmierung erfolgreich, so folgt in Programmschritt 37 erneut ein Ladevorgang des neuen Programmiermoduls, der jetzt im Speicherbereich 23 eingetragen ist in den flüchtigen Speicher 12. Das neue Programmiermodul wird anschließend gestartet. Danach erfolgt die Programmierung des Bereiches 20 des löschbaren, nichtflüchtigen Speichers 12. Im Programmschritt 38 erfolgt der Lösch- und Programmiervorgang dieses Bereiches. Er findet analog zu dem Programmschritt 34 statt. Dabei ist jedoch möglich, daß die Programmierroutine an sich gegenüber der ursprünglichen Programmierroutine in den Programmschritten 34 verbessert ist (z.B. hinsichtlich der Programmierzeit). Im Programmschritt 39 erfolgt dann die überprüfung des in den Bereich 20 eingeschriebenen Speicherinhaltes wie im Programmschritt 35. In Abfrage 40 wird dann durch Vergleich der ermittelten Checksumme mit der vorgegebenen Checksumme überprüft, ob der Bereich 20 ordnungsgemäß programmiert ist. Ist dies nicht der Fall, so wird der Programmiervorgang wiederholt. Dafür werden dann die Programmschritte 38 und 39 nochmals abgearbeitet. War der Programmiervorgang erfolgreich, so ist der gesamte Speicher 12 mit neuem Speicherinhalt versehen und das Programm zur Programmierung dieses Speichers wird im Programmschritt 51 beendet.

Für den Fall, daß in der Abfrage 32 der Speicherinhalt des Bereiches 20 als fehlerhaft erkannt wurde, wird im Programmschritt 41 der Speicherinhalt des Bereiches 21 überprüft. In Abfrage 42 erfolgt dann die Entscheidung, ob der Speicherinhalt des Bereiches 21 fehlerfrei ist oder nicht. Wird der Speicherinhalt des Bereichs 21 als fehlerhaft erkannt, so wird der gesamte Programmiervorgang mit Programmschritt 51 beendet. Wird der Speicherinhalt des Bereiches 21 als fehlerfrei erkannt, so wird dann das Programmiermodul, das sich im Speicherbereich 23 befindet, in den flüchtigen Speicher 13 des Steuergerätes 10 eingeladen und gestartet. Dies geschieht im Programmschritt 43 analog zu Programmschritt 33. Danach erfolgt dann im Programmschritt 44 das Löschen und Neuprogrammieren des Speicherbereichs 20. Auch dies geschieht analog zu dem Programmschritt 34 bzw. 38. Die Programmierung des Bereichs 20 wird dann im Programmschritt 45 überprüft. Ergeht in Abfrage 46 das Überprüfungsergebnis, daß dieser Bereich nicht ordnungsgemäß programmiert wurde, so wird die Programmierung dieses Bereichs 20 wiederholt. Dazu werden die Programmschritte 44 und 45 wiederholt. War die Programmierung erfolgreich, so wird im Programmschritt 47 das Programmiermodul, das neu in den Bereich 20 eingeschrieben wurde, in den flüchtigen Speicher 13 geladen und gestartet. Während dieser Abarbeitung wird dann im Programmschritt 48 der Bereich 21 gelöscht und mit den neuen Daten programmiert. Im Programmschritt 49 erfolgt wieder die Überprüfung dieses Bereiches. Auch hier erfolgt eine Wiederholung der Programmierung, wenn in Abfrage 50 ein Fehler bei dem vorhergehenden Programmiervorgang festgestellt wird. War der Programmiervorgang erfolgreich, so ist der gesamte Speicherinhalt des Speichers 12 neu programmiert und der Programmiervorgang kann in Programmschritt 51 beendet werden.

Die Erfindung ist nicht auf das hier vorgestellte Ausführungsbeispiel beschränkt. Sie ist vielfältig abwandelbar. So ist es z.B. möglich, um Speicherplatz in dem löschbaren, nichtflüchtigen Speicher 12 zu sparen, bei Fertigstellung des Steuergerätes, d.h. bei der erstmaligen Programmierung des löschbaren, nichtflüchtigen Speichers 12 ein Programmiermodul nur in einem z.B. im ersten Bereich 20 vorzusehen. In diesem Fall muß jedoch vor der Löschung des Bereiches 20 der Bereich 21 in einem Zwischenschritt mit dem Programmiermodul aus dem Bereich 20 überschrieben werden.

Weiterhin könnte z.B. bei den Programmschleifen, die sich ergeben, wenn in den Abfragen 36, 40, 46 und 50 der negative Entscheidungszweig auftritt, ein Abbruchkriterium vorgesehen sein, das die Anzahl der Schleifendurchläufe auf einen bestimmten Wert beschränkt.

Das Programmiermodul muß nicht mit allen in Anspruch 3 aufgeführten Komponenten im nichtflüchtigen, löschbaren Speicher eingeschrieben sein. In einer Abwandlung des Ausführungsbeispiels ist es vielmehr auch möglich, nur einen wichtigen Teil, wie z.B. das Modul zur Kommunikation mit dem externen elektrischen Gerät, das Modul zur Prüfung der Zugriffsberechtigung des externen elektronischen Gerätes und das Modul zum Laden des Programmiermoduls in den flüchtigen Speicher 13 in den nichtflüchtigen, löschbaren Speicher 12 einzuschreiben. Die restlichen nötigen Teile des Programmiermoduls können dann einfach von dem externen elektronischen Gerät in den flüchtigen Speicher 13 nachgeladen werden.

## Patentansprüche

1. Verfahren zur vollständigen Neuprogrammierung eines löschbaren, nichtflüchtigen Speichers (12) in einem Steuergerät (10), insbesondere Kraftfahrzeug-Steuergerät wobei das Steuergerät mindestens eine Zentraleinheit (11), einen flüchtigen Speicher (13), einen löschbaren nichtflüchtigen Speicher (12) sowie Ein-/Ausgabeschaltkreise (15) enthält, wobei die Zentraleinheit zur Programmierung des löschbaren, nichtflüchtigen Speichers ein Programmiermodul abarbeitet, wobei das Steuergerät die zu programmierenden Daten von einem externen elektronischen Gerät (18) empfängt, wobei der löschbare, nichtflüchtige Speicher (12) in mindestens zwei getrennt lösch- und programmierbare Bereiche (20,21) eingeteilt wird und vor dem eigentlichen Programmiervorgang das Programmiermodul in mindestens einen der mindestens zwei getrennt lösch- und programmierbaren Bereiche (20,21) eingeschrieben ist, dadurch gekennzeichnet, daß vor dem eigentlichen Aufruf des Programmiermoduls mindestens die Speicherinhalte des Bereichs des löschbaren nichtflüchtigen Speichers (12) in dem das Programmiermodul enthalten ist, auf Richtigkeit überprüft werden und daß nur dann das Programmiermodul gestartet wird und der andere der mindestens zwei getrennt lösch- und programmierbaren Bereiche des löschbaren, nichtflüchtigen Speichers (12) neu programmiert wird, wenn das Programmiermodul in dem ersten Bereich des löschbaren, nichtflüchtigen Speichers (12) als fehlerfrei erkannt worden ist.

2. Verfahren nach Anspruch 1, dadurch gekennzeichnet, daß das Programmiermodul jeweils von dem entsprechenden Bereich (20, 21) in den flüchtigen Speicher (13) geladen wird und daß die Abarbeitung des Programmiermoduls anschließend gestartet wird, wobei der flüchtige Speicher (13) als Programmspeicher verwendet wird.

3. Verfahren nach Anspruch 2, dadurch gekennzeichnet, daß das Programmiermodul insbesondere ein Modul zur Kommunikation mit dem externen elektronischen Gerät (18), ein Modul zur Prüfung der Zugriffsberechtigung des externen elektronischen Geräts (18), ein Modul zum Laden des Programmiermoduls in den flüchtigen Speicher (13), und ein Modul zur Löschung und Programmierung des löschbaren, nichtflüchtigen Speichers (12) enthält.

4. Verfahren nach Anspruch 3, dadurch gekennzeichnet, daß nur ein Teil der Module des Programmiermoduls in den löschbaren, nichtflüchtigen Speicher (12) eingeschrieben wird und die restlichen Module des Programmiermoduls von dem externen, elektrischen Gerät (18) in den flüchtigen Speicher (13) nachgeladen werden.

5. Verfahren nach Anspruch 4, dadurch gekennzeichnet, daß zur Überprüfung der Speicherinhalte eine Checksumme berechnet wird, die mit einer ebenfalls in dem löschbaren, nichtflüchtigen Speicher (12) eingetragenen Wert verglichen wird und daß der Speicherinhalt als fehlerfrei erkannt wird, wenn die berechnete Checksumme mit dem eingetragenen Wert übereinstimmt.

6. Verfahren nach einem der vorhergehenden Ansprüche, dadurch gekennzeichnet, daß nach der Programmierung jedes der mindestens zwei getrennt lösch- und programmierbaren Bereiche (20, 21) die Speicherinhalte dieser Bereiche (20, 21) auf Fehlerfreiheit überprüft werden und daß nur dann der nächste Bereich (20, 21) programmiert wird, wenn der zuvor programmierte Bereich als fehlerfrei erkannt wird, wobei die Programmierung des zuvor programmierten Bereichs wiederholt wird, wenn dieser Bereich nicht als fehlerfrei erkannt wird.

7. Verfahren nach einem der vorhergehenden Ansprüche, dadurch gekennzeichnet, daß das Programmiermodul in jeden der mindestens zwei getrennt lösch- und programmierbaren Bereiche (20, 21) zusammen mit der Programmierung eines Steuerprogramms für das Steuergerät (10) nach Fertigstellung der Produktion des Steuergerätes (10) in die zwei getrennt lösch- und programmierbaren Bereiche (20, 21) des löschbaren, nichtflüchtigen Speichers (12) eingeschrieben wird.

8. Verfahren nach einem der vorhergehenden Ansprüche 1 bis 7, dadurch gekennzeichnet, daß das Programmiermodul nach Fertigstellung der Produktion des Steuergerätes (10) nur in einen ersten Bereich (20) des löschbaren, nichtflüchtigen Speichers (12) eingeschrieben wird und daß die Einschreibung des Programmiermoduls in den mindestens einen weiteren Bereich (21) des löschbaren, nichtflüchtigen Speichers (12) vor der Löschung des ersten Bereiches (20) durchgeführt wird.

## Claims

1. Method for completely reprogramming an erasable, non-volatile memory (12) in a control device (10), in particular motor vehicle control device, in which the control device contains at least one central unit (11), a volatile memory (13), an erasable, non-volatile memory (12) and also input/output circuits (15), in which the central unit for programming the erasable, non-volatile memory executes a programming module, in which the control device receives the data to be programmed from an external electronic device (18), in which the erasable, non-volatile memory (12) is divided into at least two areas (20, 21) that can be erased and programmed separately and before the actual programming operation the programming module is written into at least one of the at least two areas (20, 21) that can be erased and programmed separately, characterized in that , before the programming module is actually invoked, the correctness of at least the memory contents of the area of the erasable, non-volatile memory (12) containing the programming module is checked, and in that the programming module is started and the other of the at least two areas that can be erased and programmed separately of the erasable, non-volatile memory (12) is reprogrammed only if the programming module in the first area of the erasable, non-volatile memory (12) has been identified as error-free.

2. Method according to Claim 1, characterized in that the programming module is loaded in each case from the respective area (20, 21) into the volatile memory (13), and in that execution of the programming module is subsequently started, the volatile memory (13) being used as program memory.

3. Method according to Claim 2, characterized in that the programming module contains in particular a module for communicating with the external electronic device (18), a module for checking the access authorization of the external electronic device (18), a module for loading the programming module into the volatile memory (13) and a module for erasing and programming the erasable, non-volatile memory (12).

4. Method according to Claim 3, characterized in that only some of the modules of the programming module are written into the erasable, non-volatile memory (12) and the remaining modules of the programming module are subsequently loaded into the volatile memory (13) from the external electrical device (18).

5. Method according to Claim 5, characterized in that, for checking the memory contents, a checksum is calculated which is compared with a value likewise entered in the erasable, non-volatile memory (12), and in that the memory contents are identified as error-free if the calculated checksum matches the entered value.

6. Method according to one of the preceding claims, characterized in that, after each of the at least two areas (20, 21) that can be erased and programmed separately have been programmed, it is checked whether the memory contents of these areas (20, 21) are error-free, and in that the next area (20, 21) is programmed only if the previously programmed area is identified as error-free, the programming of the previously programmed area being repeated if this area is not identified as error-free.

7. Method according to one of the preceding claims, characterized in that the programming module in each of the at least two areas (20, 21) that can be erased and programmed separately is written together with the programming of a control program for the control device (10) after finishing production of the control device (10) into the two areas (20, 21) that can be erased and programmed separately of the erasable, non-volatile memory (12).

8. Method according to one of the preceding Claims 1 to 7, characterized in that the programming module is written into only one first area (20) of the erasable, non-volatile memory (12) after finishing production of the control device (10), and in that the programming module is written into the at least one further area (21) of the erasable, non-volatile memory (12) before the first area (20) is erased.

## Revendications

1. Procédé de reprogrammation complète d'une mémoire (12), non volatile, effaçable, dans un appareil de commande (10), notamment un appareil de commande d'un véhicule automobile, selon lequel
- l'appareil de commande comprend au moins une unité centrale (11), une mémoire volatile (13), une mémoire non volatile effaçable (12) ainsi que des circuits entrée/sortie (15),
- l'unité centrale traitant un module de programmation pour programmer la mémoire non volatile effaçable,
- l'appareil de commande recevant les données à programmer d'un appareil électronique (18) externe,
- la mémoire non volatile effaçable (12) étant subdivisée en au moins deux zones (20, 21) effaçables et programmables séparément et, avant la programmation proprement dite, le module de programmation est inscrit dans au moins l'une des deux zones (20, 21) effaçables et programmables séparément,
caractérisé en ce qu'
- avant l'appel proprement dit du module de programmation, on vérifie pour exactitude au moins les contenus de mémoire de la zone de la mémoire non volatile effaçable (12) qui contient le module de programmation et
- seulement alors on démarre le module de programmation et on reprogramme l'autre des deux zones effaçables et programmables séparément, de la mémoire non volatile effaçable (12) si le module de programmation dans la première zone de la mémoire non volatile effaçable (12) a été reconnu comme sans erreur.

2. Procédé selon la revendication 1,
caractérisé en ce qu'
- on charge le module de programmation (14), chaque fois de la zone correspondante (20, 21), dans la mémoire volatile (13) et
- on démarre alors le traitement du module de programmation en utilisant la mémoire volatile (13) comme mémoire de programme.

3. Procédé selon la revendication 2,
caractérisé en ce que
le module de programmation comporte notamment un module de communication avec l'appareil électronique externe (18), un module pour contrôler l'autorisation d'accès de l'appareil électronique externe (18), un module pour charger le module de programmation dans la mémoire volatile (13) et un module pour effacer et programmer la mémoire non volatile effaçable (12).

4. Procédé selon la revendication 3,
caractérisé en ce qu'
on inscrit seulement une partie des modules du module de programmation dans la mémoire non volatile effaçable (12) et on recharge les modules restants du module de programmation de l'appareil électrique externe (18) dans la mémoire volatile (13).

5. Procédé selon la revendication 4,
caractérisé en ce que
- pour contrôler les contenus de mémoire on calcule une somme de contrôle qui est comparée à une valeur également enregistrée dans la mémoire effaçable non volatile (12) et
- on estime que le contenu de la mémoire est sans défaut si la somme de contrôle, calculée, coïncide avec la valeur enregistrée.

6. Procédé selon l'une des revendications précédentes,
caractérisé en ce qu'
- après la programmation d'au moins chacune des deux zones (20, 21) programmables et effaçables séparément, on vérifie que les contenus des mémoires de ces zones (20, 21) sont sans défaut et
- ce n'est qu'alors que l'on programme la zone suivante (20, 21) si la zone programmée précédemment a été reconnue comme sans défaut, la programmation de la zone programmée préalablement étant répétée si cette zone est reconnue comme n'étant pas sans défaut.

7. Procédé selon l'une des revendications précédentes,
caractérisé en ce qu'
on inscrit le module de programmation au moins dans chacune des deux zones (20, 21) effaçables et programmables séparément avec la programmation d'un programme de commande pour l'appareil de commande (10) après la fin de la production de l'appareil de commande (10) dans les deux zones effaçables et programmables séparément (20, 21) de la mémoire non volatile effaçable (12).

8. Procédé selon l'une des revendications précédentes 1 à 7,
caractérisé en ce qu'
- après la fin de la fabrication de l'appareil de commande (10), on inscrit le module de programmation seulement dans une première zone (20) de la mémoire non volatile effaçable (12) et
- on inscrit le module de programmation au moins dans une autre zone (21) de la mémoire non volatile, effaçable (12), avant d'effacer la première zone (20).
